# DEMANDE DE BREVET EUROPEEN

(11) **EP 2 293 327 A1**
(43) Date de publication de la demande: **09.03.2011**
(21) Numéro de dépôt: 10174497.7
(22) Date de dépôt: 30.08.2010
(51) Int. Cl.: H01L 21/822, H01L 21/8234, H01L 21/8238, H01L 27/06, H01L 29/49

(54) **Circuit intégré à transistors MOS couplés électrostatiquement et procédé de réalisation d'un tel circuit intégré**

(30) Priorité: 07.09.2009 FR 0956081
(71) Demandeur: Commissariat à l'Énergie Atomique et aux Énergies Alternatives, 75015 Paris (FR)
(72) Inventeur: Augendre, Emmanuel, 38330, MONTBONNOT (FR); Vinet, Maud, 38140, RIVES (FR); Clavelier, Laurent, 38000, GRENOBLE (FR); Batude, Perrine, 21000, DIJON (FR)
(74) Mandataire: Ilgart, Jean-Christophe

(57) **Abrégé**

Circuit intégré (100) comportant :
- un premier transistor (101a) ;
- un second transistor (101b), disposé sur le premier transistor, dont une région de canal (109b) est formée dans une couche (104b) de semi-conducteur comportant deux faces principales (106b, 108b) sensiblement parallèles ;
- une portion (117) d'un matériau électriquement conducteur reliée électriquement à une grille (113a) du premier transistor et disposée entre la grille du premier transistor et la région de canal du second transistor ;
- une couche (103) diélectrique disposée entre la portion du matériau électriquement conducteur et la région de canal du second transistor ;

et dans lequel
la section de la région de canal du second transistor est incluse dans la section de la portion du matériau électriquement conducteur, et
la région de canal du second transistor est disposée entre la portion du matériau électriquement conducteur et une grille du second transistor.

## Description

### DOMAINE TECHNIQUE

L'invention concerne le domaine des circuits intégrés à transistors MOS superposés, c'est-à-dire pouvant comporter plusieurs niveaux empilés de transistors MOS, et couplés de manière électrostatique entre eux. L'invention concerne également un procédé de réalisation de tels circuits intégrés.

### ÉTAT DE LA TECHNIQUE ANTÉRIEURE

Dans un circuit intégré comportant des transistors MOS, ces transistors sont généralement réalisés à partir d'une unique couche de semi-conducteur dans laquelle sont formés les canaux de ces transistors. Cette couche de semi-conducteur est surmontée d'interconnexions métalliques formant des contacts reliés électriquement aux grilles et aux régions de source et de drain des transistors.

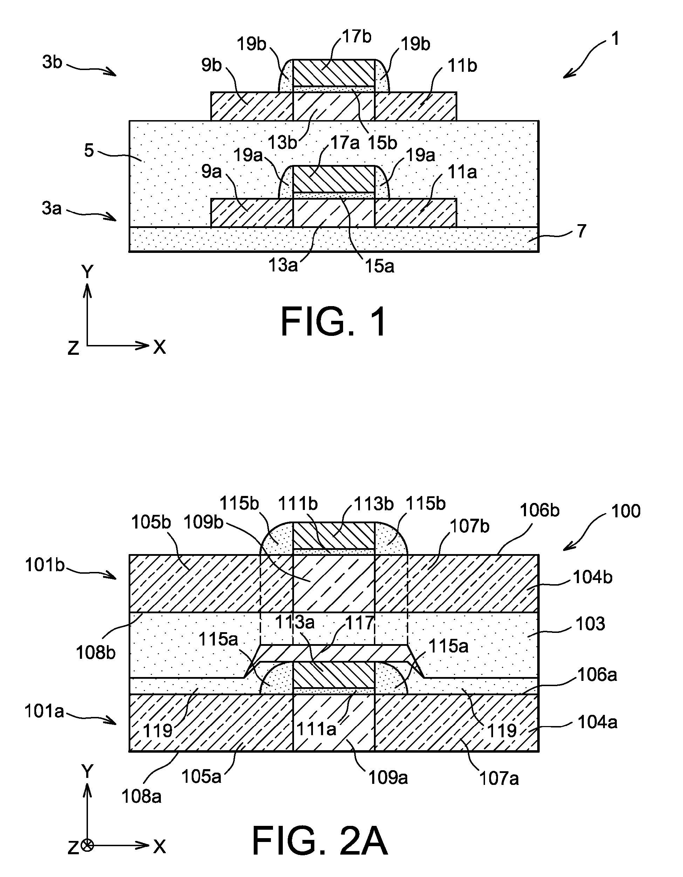

Afin d'améliorer la densité d'intégration des transistors MOS dans les circuits intégrés, il est connu de fabriquer des circuits intégrés comportant plusieurs niveaux empilés de transistors. Un exemple d'un tel circuit intégré 1 est représenté sur la figure 1. Sur cette figure 1, seuls deux transistors 3a et 3b, superposés l'un au-dessus de l'autre, du circuit intégré 1 sont représentés. Le transistor supérieur 3b est réalisé sur une couche diélectrique 5 recouvrant le transistor inférieur 3a qui est lui-même réalisé sur une couche diélectrique 7, correspondant par exemple à la couche diélectrique enterrée d'un substrat SOI (silicium sur isolant). Chaque transistor 3a, 3b comporte une portion de semi-conducteur dans laquelle sont réalisées les régions de source 9a, 9b et de drain 11a, 11b ainsi qu'une région 13a, 13b destinée à former le canal du transistor 3a, 3b. Un diélectrique de grille 15a, 15b surmonté d'une grille 17a, 17b sont disposés sur la région de canal 13a, 13b de chaque transistor 3a, 3b, la région de canal 13a, 13b de chaque transistor 3a, 3b. Chaque empilement formé par une des grilles 17a, 17b et un des diélectriques de grille 15a, 15b est entouré par des espaceurs 19a, 19b formés par un ou plusieurs matériaux diélectriques.

Par rapport à des transistors réalisés à partir d'une seule couche de semi-conducteur, une telle structure permet d'augmenter la densité d'intégration des transistors dans le circuit intégré. De plus, une telle structure permet de moduler l'état électrique de l'interface entre la région 13b destinée à former le canal du transistor supérieur 3b et la couche diélectrique 5, voire, dans le cas de transistors FD (« fully depleted » en anglais, ou totalement désertés) de coupler de manière électrostatique les transistors qui sont superposés les uns aux autres. Ainsi, sur l'exemple représenté sur la figure 1, la grille 17a du transistor inférieur 3a peut servir à polariser le canal 13b du transistor supérieur 3b, notamment grâce à la faible épaisseur de la couche diélectrique 5, cette épaisseur étant par exemple inférieure à environ 50 nm, ou inférieure à environ 30 nm ou même 10 nm.

L'efficacité d'un tel couplage électrostatique est directement conditionnée par l'alignement vertical (alignement selon l'axe y représenté sur la figure 1) entre la grille 17a du transistor inférieur 3a et le canal 13b du transistor supérieur 3b. Ainsi, ces deux transistors 3a, 3b sont correctement couplés dans le cas où la grille 17a du transistor inférieur 3a est bien alignée avec le canal 13b du transistor supérieur 3b, comme c'est le cas sur la figure 1. Par contre, dans le cas où ces éléments ne sont plus correctement alignés l'un par rapport à l'autre, des difficultés peuvent alors apparaître pour polariser le canal 13b par l'intermédiaire de la grille 17a.

Un tel circuit intégré 1 peut être obtenu en réalisant séparément les niveaux inférieur et supérieur (comportant respectivement le transistor inférieur 3a et le transistor supérieur 3b), puis en les assemblant l'un à l'autre par l'intermédiaire de la couche diélectrique 5. Il est toutefois difficile d'obtenir, avec cette technique, un bon alignement entre les transistors des différents niveaux, les meilleurs résultats obtenus permettant d'obtenir un alignement de l'ordre de 100 nm.

Afin d'obtenir un meilleur alignement, il est préférable de fabriquer le circuit intégré 1 en réalisant séquentiellement les différents niveaux de transistors: on réalise tout d'abord le niveau inférieur comportant le transistor inférieur 3a, puis on réalise le niveau supérieur, comportant le transistor supérieur 3b, directement sur le niveau inférieur en alignant la grille 17b du transistor supérieur 3b par rapport à la grille 17a du transistor inférieur 3a lors de l'étape de lithographie mise en oeuvre pour la réalisation de cette grille 17b.

Bien que l'alignement obtenu avec une réalisation séquentielle des niveaux de transistors soit meilleur que l'alignement obtenu par la réalisation séparée puis l'assemblage des niveaux de transistors, il existe toujours une incertitude d'alignement au moins égale à environ 40% de la longueur minimale (dimension selon l'axe x représenté sur la figure 1) de grille des transistors.

### EXPOSÉ DE L'INVENTION

Un but de la présente invention est de proposer un circuit intégré à transistors MOS superposés et pouvant être couplés entre eux de manière électrostatique, dont la structure garantit le couplage électrostatique entre deux transistors MOS superposés du circuit intégré, et qui soit peu ou pas sensible à un désalignement pouvant apparaître entre les deux transistors lors de la réalisation du circuit intégré.

Pour cela, il est proposé un circuit intégré comportant au moins un premier transistor de type MOS sur lequel est disposé au moins un second transistor de type MOS dont une région de canal est formée dans au moins une couche à base de semi-conducteur comportant deux faces principales sensiblement parallèles, et comportant au moins une portion d'au moins un matériau électriquement conducteur reliée électriquement à une grille du premier transistor et disposée entre la grille du premier transistor et la région de canal du second transistor, la section de la région de canal du second transistor dans un plan parallèle aux deux faces principales de la couche à base de semi-conducteur étant incluse dans la section de la portion du matériau électriquement conducteur projetée dans ledit plan.

La section de la région de canal du second transistor dans le plan parallèle aux deux faces principales de la couche à base de semi-conducteur est incluse dans la section de la portion de matériau électriquement conducteur projetée dans ledit plan, ce qui traduit le fait que les dimensions de la section de la portion de matériau électriquement conducteur projetée dans ledit plan sont supérieures aux dimensions de la section de la région de canal du second transistor dans ledit plan. Ainsi, il est possible de garantir un couplage électrostatique entre le canal du transistor supérieur et la grille du transistor inférieur même dans le cas où un désalignement entre les transistors apparait lors de la réalisation du circuit intégré.

L'invention concerne notamment un circuit intégré comportant au moins :
- un premier transistor de type MOS ;
- un second transistor de type MOS, disposé sur le premier transistor de type MOS, dont une région de canal est formée dans au moins une couche à base de semi-conducteur comportant deux faces principales sensiblement parallèles ;

- une portion d'au moins un matériau électriquement conducteur reliée électriquement à une grille du premier transistor et disposée entre la grille du premier transistor et la région de canal du second transistor ;
- une couche à base d'au moins un matériau diélectrique disposée au moins entre la portion du matériau électriquement conducteur et la région de canal du second transistor ;
   et dans lequel
   la section de la région de canal du second transistor dans un plan parallèle aux deux faces principales de la couche à base de semi-conducteur est incluse dans la section de la portion du matériau électriquement conducteur projetée dans ledit plan, et
   la région de canal du second transistor est disposée entre la portion du matériau électriquement conducteur et une grille du second transistor.

La portion du matériau électriquement conducteur peut être disposée sur et/ou contre la grille du premier transistor.

Les dimensions de la section de la portion du matériau électriquement conducteur projetée dans le plan parallèle aux deux faces principales de la couche à base de semi-conducteur peuvent être supérieures d'au moins 10%, ou 20%, ou 30%, ou 40%, ou 50% par rapport aux dimensions de la section de la région de canal du second transistor dans ledit plan.

Les dimensions de la section de la grille du premier transistor projetée dans le plan parallèle aux deux faces principales de la couche à base de semi-conducteur peuvent être sensiblement égales aux dimensions de la section de la région de canal du second transistor dans ledit plan.

Le circuit intégré peut comporter en outre au moins une couche à base d'au moins un matériau diélectrique disposée au moins entre la portion du matériau électriquement conducteur et la région de canal du second transistor. Ce matériau diélectrique peut être à base d'oxyde de silicium et/ou d'un oxyde à forte permittivité (high-K) tel que par exemple de l'HfO₂ et/ou du ZrO₂ et/ou de l'Al₂O₃.

Dans ce cas, l'épaisseur de la couche à base du matériau diélectrique peut être comprise entre environ 1 nm et 500 nm, et de préférence entre environ 5 nm et 50 nm.

Le circuit intégré peut comporter au moins deux niveaux de transistors de type MOS superposés deux à deux, chaque niveau pouvant comporter plusieurs transistors MOS.

Dans ce cas, il est possible que des portions d'au moins un matériau électriquement conducteur soient reliées électriquement aux grilles de chacun des transistors du niveau inférieur pour réaliser un couplage électrostatique entre les canaux des transistors supérieurs et les grilles des transistors inférieurs. Toutefois, il est également possible qu'une partie seulement des transistors inférieurs comportent une portion de matériau électriquement conducteur couplant électrostatiquement les grilles de ces transistors inférieures avec les canaux des transistors supérieurs qui sont superposés à ces transistors inférieurs. Les matériaux électriquement conducteurs peuvent être similaires ou différents d'un transistor à l'autre en fonction du couplage électrostatique que l'on souhaite obtenir.

La portion du matériau électriquement conducteur peut comporter au moins un empilement de plusieurs matériaux électriquement conducteurs. Ce ou ces matériaux pouvant former la portion du matériau électriquement conducteur peuvent être choisis notamment en fonction de leur aptitude à être planarisés et/ou en fonction de leur travail de sortie qui influe directement sur les caractéristiques du transistor supérieur en le décalant soit vers les hautes performances (par abaissement de la tension de seuil) soit vers une basse consommation (par augmentation de la tension de seuil).

Dans ce cas, la portion du matériau électriquement conducteur peut comporter au moins une portion de titane disposée entre une portion de tungstène et une portion à base de nitrure de titane.

Il est également proposé un procédé de réalisation d'un circuit intégré, comportant au moins les étapes de :
a) réalisation d'au moins un premier transistor de type MOS,
b) réalisation d'au moins une portion d'au moins un matériau électriquement conducteur reliée électriquement à une grille du premier transistor,
c) réalisation d'au moins un second transistor de type MOS sur le premier transistor, une région de canal du second transistor étant formée dans au moins une couche à base de semi-conducteur comportant deux faces principales sensiblement parallèles, la portion du matériau électriquement conducteur étant disposée entre la grille du premier transistor et la région de canal du second transistor,
   la section de la région de canal du second transistor dans un plan parallèle aux deux faces principales de la couche à base de semi-conducteur étant incluse dans la section de la portion du matériau électriquement conducteur projetée dans ledit plan.

L'invention concerne également un procédé de réalisation d'un circuit intégré, comportant au moins les étapes de :
- réalisation d'au moins un premier transistor de type MOS,
- réalisation d'au moins une portion d'au moins un matériau électriquement conducteur reliée électriquement à une grille du premier transistor,
- dépôt d'au moins une couche diélectrique recouvrant au moins la portion du matériau électriquement conducteur,
- réalisation d'au moins un second transistor de type MOS sur le premier transistor, une région de canal du second transistor étant formée dans au moins une couche à base de semi-conducteur comportant deux faces principales sensiblement parallèles et disposée sur la couche diélectrique, la portion du matériau électriquement conducteur étant disposée entre la grille du premier transistor et la région de canal du second transistor,
   et dans lequel
   la section de la région de canal du second transistor dans un plan parallèle aux deux faces principales de la couche à base de semi-conducteur est incluse dans la section de la portion du matériau électriquement conducteur projetée dans ledit plan, et
   la région de canal du second transistor est disposée entre la portion du matériau électriquement conducteur et une grille du second transistor.

L'étape de réalisation de la portion du matériau électriquement conducteur peut être obtenue par la mise en oeuvre des étapes suivantes :
- dépôt conforme d'une première couche diélectrique sur le premier transistor,
- dépôt d'une seconde couche diélectrique sur la première couche diélectrique,
- planarisation de la seconde couche diélectrique avec arrêt sur la première couche diélectrique, révélant une partie de la première couche diélectrique recouvrant le sommet de la grille du premier transistor,
- gravure de ladite partie de la première couche diélectrique, révélant au moins le sommet de la grille du premier transistor,
- dépôt d'au moins une couche à base du matériau électriquement conducteur au moins sur la grille du premier transistor et sur des portions restantes de la seconde couche diélectrique,
- planarisation de la couche à base du matériau électriquement conducteur, formant la portion du matériau électriquement conducteur reliée électriquement à la grille du premier transistor.

Le procédé peut comporter en outre, entre l'étape b) de réalisation de la portion du matériau électriquement conducteur et l'étape c) de réalisation du second transistor, une étape de dépôt d'au moins une couche diélectrique recouvrant au moins la portion du matériau électriquement conducteur, la couche à base de semi-conducteur étant disposée sur ladite couche diélectrique.

Ce procédé peut être mis en oeuvre afin que le circuit intégré puisse comporter au moins deux niveaux de transistors de type MOS superposés deux à deux, chaque niveau pouvant comporter plusieurs transistors MOS.

Dans ce cas, des portions d'au moins un matériau électriquement conducteur peuvent être reliées électriquement aux grilles de chacun ou d'une partie des transistors du niveau inférieur pour réaliser un couplage électrostatique entre les canaux des transistors supérieurs et les grilles des transistors inférieurs.

Dans une variante, la ou les portions de matériau électriquement conducteur peuvent être réalisées par un procédé de photolithographie standard.

### BRÈVE DESCRIPTION DES DESSINS

La présente invention sera mieux comprise à la lecture de la description d'exemples de réalisation donnés à titre purement indicatif et nullement limitatif en faisant référence aux dessins annexés sur lesquels :
- la figure 1 représente un exemple de circuit intégré comportant plusieurs niveaux empilés de transistors MOS selon l'art antérieur,
- les figures 2A et 2B représentent des exemples de réalisation d'un circuit intégré à transistors MOS couplés de manière électrostatique, objet de la présente invention, selon un mode de réalisation particulier,
- les figures 3A à 3J représentent les étapes d'un procédé de réalisation d'un circuit intégré à transistors MOS couplés de manière électrostatique, également objet de la présente invention, selon un mode de réalisation particulier.

Des parties identiques, similaires ou équivalentes des différentes figures décrites ci-après portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

On se réfère tout d'abord à la figure 2A qui représente un exemple de réalisation d'un circuit intégré 100 à transistors MOS couplés entre eux de manière électrostatique, selon un mode de réalisation particulier.

Sur cette figure 2A, le circuit intégré 100 comporte deux niveaux de transistors MOS. De plus, seuls deux transistors 101a et 101b superposés l'un au-dessus de l'autre du circuit intégré 100 sont représentés sur la figure 2A. Le transistor supérieur 101b est réalisé sur une couche diélectrique 103, par exemple à base de SiO₂, recouvrant le transistor inférieur 101a qui est lui-même réalisé sur une couche diélectrique, non représentée sur la figure 2A, qui est par exemple la couche diélectrique enterrée, par exemple à base de SiO₂, d'un substrat SOI (silicium sur isolant). En variante, il est possible que le transistor inférieur 101a soit réalisé sur un substrat massif, par exemple à base de silicium. Chaque transistor 101a, 101b comporte une portion d'une couche, respectivement référencées 104a, et 104b, à base d'un matériau semi-conducteur, par exemple du silicium, dans laquelle sont réalisées les régions de source 105a, 105b et de drain 107a, 107b ainsi qu'une région 109a, 109b destinée à former le canal du transistor 101a, 101b. Les couches 104a, 104b de semi-conducteur sont de forme sensiblement plane et comportent chacune deux faces principales 106a, 106b et 108a, 108b sensiblement parallèles l'une par rapport à l'autre, et parallèles au plan (X,Z) représenté sur la figure 2A.

Pour chaque transistor 101a, 101b, un diélectrique de grille 111a, 111b, par exemple à base de SiO₂ ou d'un matériau diélectrique à forte permittivité (High-K), c'est-à-dire dont la permittivité est supérieure à environ 3,9, par exemple du Ta₂O₅, surmonté d'une grille 113a, 113b, par exemple à base d'un métal tel que du tungstène ou d'un semi-conducteur polycristallin dopé, sont disposés sur la région de canal 109a, 109b de chaque transistor 101a, 101b. Chaque empilement formé par une grille 113a, 113b et un diélectrique de grille 111a, 111b est entouré par des espaceurs 115a, 115b à base d'un ou plusieurs matériaux diélectriques, et par exemple à base de SiO₂ et/ou de Si₃N₄.

Le circuit intégré 100 comporte également des portions diélectriques 119 recouvrant les régions de source 105a et de drain 107a du transistor inférieur 101a. Ces portions diélectriques 119 recouvrent également au moins une partie des espaceurs 115a de ce transistor inférieur 101a. Le circuit intégré 100 comporte en outre une portion 117 à base d'un ou plusieurs matériaux électriquement conducteurs, reliée électriquement à la grille 113a du transistor inférieur 101a. Sur l'exemple de la figure 2A, cette portion électriquement conductrice 117 est disposée sur et contre la grille 113a, et recouvre totalement le sommet de la grille 113a. De plus, la portion 117 recouvre également une partie des espaceurs 115a ainsi qu'une partie des portions diélectriques 119. La section de la région de canal 109b du transistor supérieur 101b dans un plan parallèle aux deux faces principales 106b, 108b de la couche 104b à base de semi-conducteur est incluse dans la section de la portion 117 du matériau électriquement conducteur projetée dans ce plan. Les dimensions de la section de la portion électriquement conductrice 117, dans un plan parallèle au plan (X,Z), sont supérieures aux dimensions de la section de la région de canal 109b du transistor supérieur 101b dans ce même plan.

Compte tenu de la faible épaisseur de la couche diélectrique 103 entre la portion électriquement conductrice 117 et la région de canal 109b du transistor supérieur 101b, qui est par exemple comprise entre environ 1 nm et 500 nm, et avantageusement entre environ 5 nm et 50 nm, il est possible de polariser le canal du transistor supérieur 101b à partir de la grille 113a du transistor inférieur 101a, par l'intermédiaire de la portion électriquement conductrice 117. Les deux transistors 101a, 101b peuvent donc être couplés entre eux de manière électrostatique.

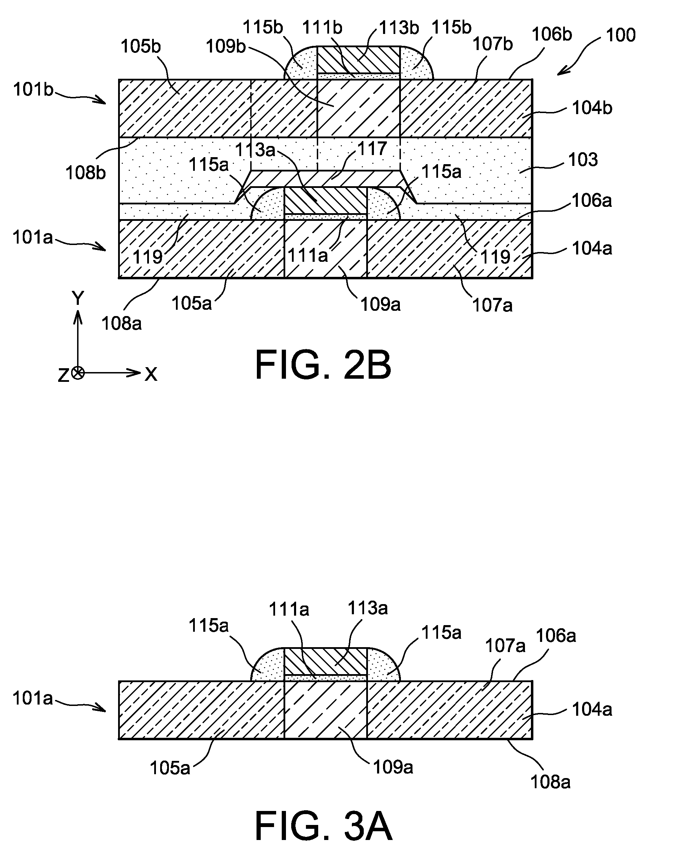

Etant donné que les dimensions (dans un plan parallèle au plan (X, Z)) de la portion électriquement conductrice 117 sont supérieures à celles de la région de canal 109b du transistor supérieur 101b dans ce même plan, on voit donc que le circuit intégré 100 tolère un désalignement entre les transistors 101a et 101b, c'est-à-dire un désalignement entre la grille 113a du transistor inférieur 101a et le canal 109b du transistor supérieur 101b. Sur l'exemple de la figure 2A, les transistors 101a et 101b sont bien alignés l'un par rapport à l'autre, ce qui ne pose pas de problème de couplage électrostatique. Par contre, sur l'exemple de la figure 2B, on voit que la grille 113a du transistor inférieur 101a n'est pas alignée avec la région de canal 109b du transistor supérieur 101b. Un tel désalignement n'aurait pas permis de réaliser un couplage électrostatique entre deux transistors superposés de l'art antérieur. Mais dans le cas présent, étant donné que la portion électriquement conductrice 117 est reliée électriquement à la grille 113a du transistor inférieur 101a et que la section de la région de canal 109b du transistor supérieur 101b dans un plan parallèle aux deux faces principales 106b, 108b de la couche 104b à base de semi-conducteur est incluse dans la section de la portion 117 de matériau électriquement conducteur projetée dans ce plan, il est donc possible de réaliser un couplage électrostatique entre ces deux transistors 101a, 101b, la grille 113a du transistor inférieur 101a pouvant polariser la région de canal 109b du transistor supérieur 101b par l'intermédiaire de la portion électriquement conductrice 117.

Les dimensions de la portion électriquement conductrice 117 sont notamment choisies en fonction du désalignement pouvant apparaître lors de la réalisation du circuit intégré 100. Par exemple, si dans une technologie donnée, la tolérance de désalignement représente environ 40% de la longueur de grille, on pourra réaliser la portion électriquement conductrice 117 telle que la longueur (dimension selon l'axe X représenté sur les figures 2A et 2B) de cette portion 117 soit au moins supérieure d'environ 40%, voire plus, par rapport à la longueur des grilles 113a, 113b des transistors 101a, 101b du circuit intégré 100. Le tableau ci-dessous donne des exemples, pour différentes longueurs de grilles (en nm), de désalignement toléré (en nm) ainsi que la longueur de la portion électriquement conductrice 117 (en nm).

| | | | | | | | | |
|---|---|---|---|---|---|---|---|---|
| L_{grille} | 27 | 24 | 22 | 18 | 17 | 15 | 14 | 13 |
| Désalignement | 11 | 10 | 9,9 | 9 | 7,1 | 6,3 | 5,6 | 5 |
| L_{portion conduc} | 38 | 34 | 31, 9 | 27 | 34, 1 | 21, 3 | 19, 6 | 18 |

Sur l'exemple des figures 2A et 2B, le circuit intégré 100 comporte deux niveaux de transistors MOS, plusieurs transistors par exemple similaires aux transistors 101a et 101b pouvant être réalisés sur chaque étage. Dans ce cas, il est possible que des portions de matériau électriquement conducteur soient reliées électriquement aux grilles de chacun des transistors du niveau inférieur, ou à une partie seulement des transistors du niveau inférieur, pour réaliser un couplage électrostatique entre les canaux des transistors supérieurs et les grilles de ces transistors inférieurs. Les matériaux électriquement conducteurs peuvent être similaires ou différents d'un transistor à l'autre en fonction du couplage électrostatique que l'on souhaite obtenir.

Sur l'exemple des figures 2A et 2B, le circuit intégré 100 comporte deux niveaux de transistors MOS superposés. Il est possible que le circuit intégré 100 comporte plus de deux niveaux de transistors superposés. Ainsi, un transistor du premier niveau peut être couplé de manière électrostatique avec un transistor du second niveau qui lui-même peut être couplé de manière électrostatique avec un transistor du troisième niveau, etc.

On se réfère maintenant aux figures 3A à 3J qui représentent les étapes d'un procédé de réalisation du circuit intégré 100 selon un mode de réalisation particulier.

Comme représenté sur la figure 3A, on réalise tout d'abord le transistor MOS inférieur 101a, par exemple à partir d'un substrat SOI. Ce transistor 101a est obtenu par la mise en oeuvre d'étapes connues de l'homme du métier qui ne seront pas détaillées ici.

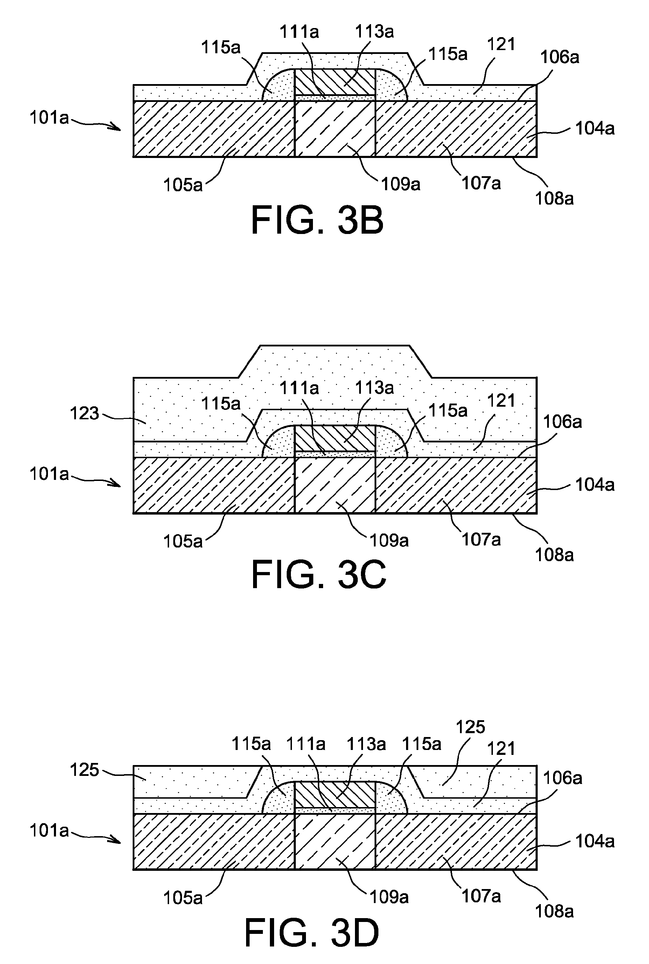

On recouvre ensuite le transistor inférieur 101a par un dépôt conforme, par exemple de type CVD (dépôt chimique en phase vapeur), d'une première couche diélectrique 121, par exemple à base de nitrure tel que du Si₃N₄ (figure 3B). Cette première couche diélectrique 121 recouvre au moins les régions de source 105a et de drain 107a, au niveau de la face supérieure 106a de la couche de semi-conducteur 104a, ainsi que les espaceurs 115a et la grille 113a du transistor inférieur 101a. L'épaisseur sensiblement constante de cette première couche diélectrique 121, par exemple comprise entre environ 5 nm et 50 nm, est choisie en fonction de la longueur souhaitée de la portion 117 électriquement conductrice qui sera réalisée par la suite. Elle est par exemple égale à environ la moitié de la différence de côtes entre la longueur de grille et la longueur de la portion électriquement conductrice.

La première couche diélectrique 121 est recouverte par une seconde couche diélectrique 123, par exemple à base d'un oxyde tel que du SiO₂, déposée par exemple par la mise en oeuvre d'un dépôt de type CVD (figure 3C). L'épaisseur de la seconde couche diélectrique 123 est par exemple choisie de sorte qu'elle soit au moins supérieure à 2,5 fois la hauteur de marche entre le haut de la grille 113a et la surface de l'isolation latérale de la zone active correspondant, dans le cas où le transistor est réalisé sur un substrat SOI, au niveau haut de l'oxyde enterré du SOI. Typiquement cette épaisseur est de l'ordre de 400 nm pour une hauteur de marche de 150 nm environ. Les matériaux de la première couche diélectrique 121 et de la seconde couche diélectrique 123 peuvent notamment être choisis afin de pouvoir graver sélectivement la seconde couche diélectrique 123 par rapport à la première couche diélectrique 121.

Comme représenté sur la figure 3D, la seconde couche diélectrique 123 est planarisée, en mettant par exemple en oeuvre une CMP (planarisation mécano-chimique), puis éventuellement gravée, avec arrêt sur la première couche diélectrique 121, formant des secondes portions diélectriques 125. Ces secondes portions diélectriques formeront par la suite une partie de la couche diélectrique 103 isolant les transistors 101a et 101b l'un de l'autre.

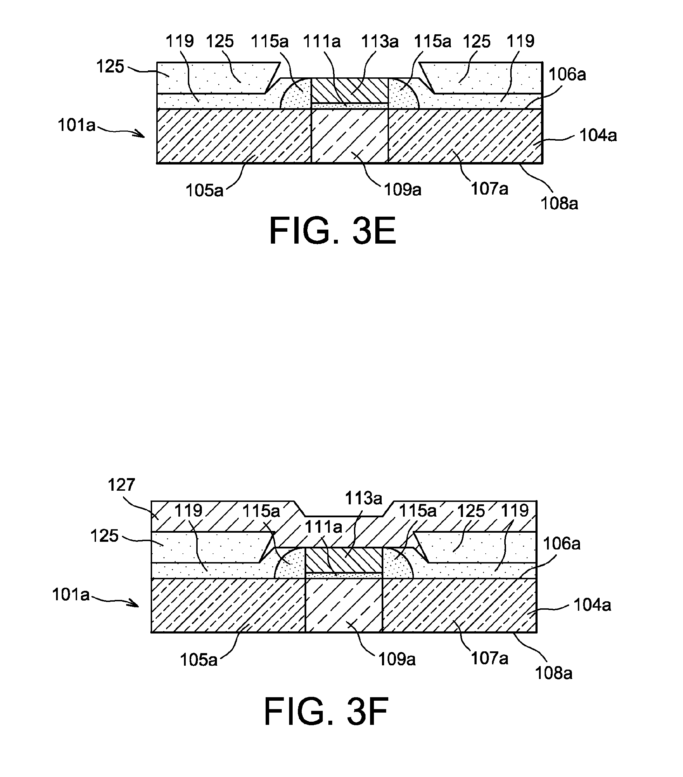

La première couche diélectrique 121 est alors gravée, par exemple par une gravure chimique, sélectivement par rapport aux secondes portions diélectriques 125 (figure 3E). Cette gravure est arrêtée au temps afin de n'exposer que le sommet de la grille 113a du transistor inférieur 101a. Cette gravure forme des premières portions diélectriques 119 qui recouvrent les régions de source 105a et de drain 107a ainsi que les espaceurs 115a.

Comme représenté sur la figure 3F, on réalise ensuite un dépôt d'un ou plusieurs matériaux électriquement conducteurs, par exemple ici un empilement 127 de trois couches à base de tungstène, de titane, et de nitrure de titane, recouvrant le sommet de la grille 113a ainsi que les secondes portions diélectriques 125 et les parties des premières portions diélectriques 119 non recouvertes par les secondes portions diélectriques 125.

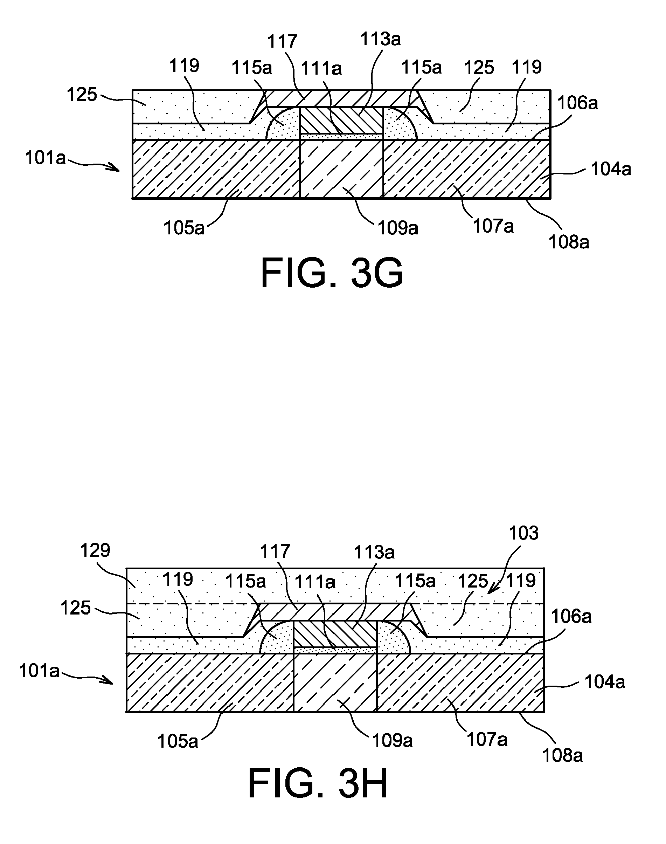

L'empilement 127 est ensuite planarisé par la mise en oeuvre d'une CMP avec arrêt sur les secondes portions diélectriques 125 (figure 3G). La portion restante de l'empilement 127 forme la portion électriquement conductrice 117 qui est électriquement en contact avec la grille 113a. De plus, la portion électriquement conductrice 117 est disposée entre les secondes portions diélectriques 125.

Comme représenté sur la figure 3H, une troisième couche diélectrique 129, par exemple à base d'oxyde tel que du SiO₂ ou d'un oxyde High-K, est ensuite déposée sur les secondes portions diélectriques 125 et sur la portion électriquement conductrice 117. L'épaisseur de la troisième couche diélectrique 129 est par exemple comprise entre environ 1 nm et 500 nm et avantageusement, notamment lorsque cette troisième couche diélectrique 129 est à base de SiO₂, entre environ 5 nm et 50 nm, ce qui permettra par la suite de réaliser un couplage électrostatique entre le grille 113a du transistor inférieur 101a et le canal 109b du transistor supérieur 101b. Cette troisième couche diélectrique 129 peut également être formée d'un empilement de plusieurs couches diélectriques de matériaux différents. Cette troisième couche diélectrique 129 et les secondes portions diélectriques 125 forment ensemble la couche diélectrique 103 destinée à isoler électriquement le transistor inférieur 101a du transistor supérieur 101b.

Un des avantages de ce procédé est qu'il permet de contrôler finement l'épaisseur du diélectrique de couplage 129 en utilisant les secondes portions diélectriques 125 comme couche d'arrêt pour la CMP réalisée. On dépose alors au niveau de la troisième couche diélectrique 129 juste ce qu'il faut comme diélectrique pour réaliser par la suite le report, par exemple le collage, de la couche 104b, assurant ainsi un bon couplage.

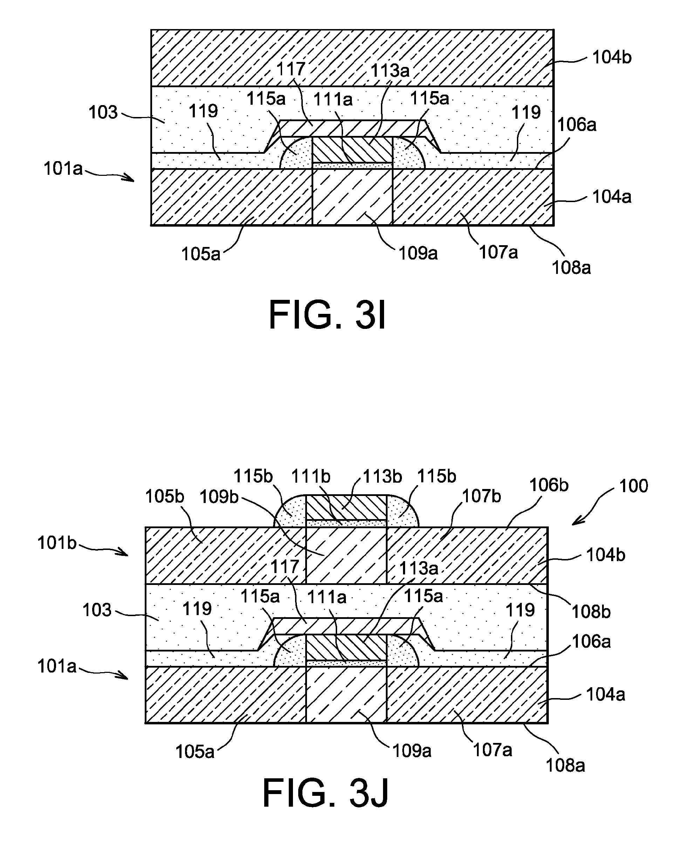

On reporte ensuite la couche 104b à base de semi-conducteur sur la couche diélectrique 103 (figure 3I). La technique mise en oeuvre pour réaliser un tel report est par exemple similaire à celle décrite dans le document « 3D CMOD Integration : Introduction of Dynamic coupling and Application to Compact and Robust 4T SRAM » de P. Batude et al., Integrated Circuit Design and Technology and Tutorial, 2008. ICICDT 2008 ; IEEE International Conference on Volume, 2-4 Juin 2008 ; Pages 281-284.

Enfin, comme représenté sur la figure 3J, le circuit intégré 100 est achevé en réalisant le transistor supérieur 101b à partir de la couche active 104b de semi-conducteur, par exemple par des étapes analogues à celles mises en oeuvre pour la réalisation du transistor inférieur 101a. Les transistors 101a et 101b du circuit intégré 100 représenté sur la figure 3J sont ici bien alignés l'un par rapport à l'autre, comme sur l'exemple de la figure 2A. Toutefois, il est possible qu'un désalignement apparaisse entre ces transistors comme sur l'exemple de la figure 2B. Ce désalignement n'aura toutefois pas de conséquence étant donné que le couplage électrostatique entre la grille 113a du transistor inférieur 101a et le canal 109b du transistor supérieur 101b sera assuré par la portion électriquement conductrice 117 disposée contre la grille 113a du transistor inférieur 101a.

Des étapes ultérieures de réalisation de contacts électriques et/ou de niveaux d'interconnexions peuvent ensuite être mises en oeuvre afin d'achever la réalisation du circuit intégré 100.

D'autres techniques peuvent bien sûr être utilisées pour réaliser les portions conductrices 117, en utilisant par exemple des techniques standards de photolithographie. On peut également réaliser ces portions conductrices par reprise d'épitaxie de silicium ou de germanium, par exemple à partir d'une grille à base de polysilicium.

Un tel circuit intégré 100 est par exemple une cellule mémoire, par exemple de type SRAM, ou ZRAM ou FPM (« Fast Page Mode » en anglais), ou un circuit logique à portes logiques CMOS.

## Revendications

1. Circuit intégré (100) comportant au moins :
- un premier transistor (101a) de type MOS ;
- un second transistor (101b) de type MOS, disposé sur le premier transistor (101a) de type MOS, dont une région de canal (109b) est formée dans au moins une couche (104b) à base de semi-conducteur comportant deux faces principales (106b, 108b) sensiblement parallèles ;
- une portion (117) d'au moins un matériau électriquement conducteur reliée électriquement à une grille (113a) du premier transistor (101a) et disposée entre la grille (113a) du premier transistor (101a) et la région de canal (109b) du second transistor (101b) ;
- une couche (103) à base d'au moins un matériau diélectrique disposée au moins entre la portion (117) du matériau électriquement conducteur et la région de canal (109b) du second transistor (101b) ;
et dans lequel
la section de la région de canal (109b) du second transistor (101b) dans un plan parallèle aux deux faces principales (106b, 108b) de la couche (104b) à base de semi-conducteur est incluse dans la section de la portion (117) du matériau électriquement conducteur projetée dans ledit plan, et
la région de canal (109b) du second transistor (101b) est disposée entre la portion (117) du matériau électriquement conducteur et une grille (113b) du second transistor (101b).

2. Circuit intégré (100) selon la revendication 1, dans lequel la portion (117) du matériau électriquement conducteur est disposée sur et/ou contre la grille (113a) du premier transistor (101a).

3. Circuit intégré (100) selon l'une des revendications précédentes, dans lequel les dimensions de la section de la grille (113a) du premier transistor (101a) dans le plan parallèle aux deux faces principales (106b, 108b) de la couche à base de semi-conducteur sont sensiblement égales aux dimensions de la section de la région de canal (109b) du second transistor (101b) dans ledit plan.

4. Circuit intégré (100) selon l'une des revendications précédentes, dans lequel l'épaisseur de la couche (103) à base du matériau diélectrique est comprise entre environ 5 nm et 50 nm.

5. Circuit intégré (100) selon l'une des revendications précédentes, comportant au moins deux niveaux de transistors de type MOS (101a, 101b) superposés deux à deux, chaque niveau comportant plusieurs transistors MOS (101a, 101b).

6. Circuit intégré (100) selon l'une des revendications précédentes, dans lequel la portion (117) du matériau électriquement conducteur comporte au moins un empilement de plusieurs matériaux électriquement conducteur.

7. Circuit intégré (100) selon l'une des revendications précédentes, dans lequel la portion (117) du matériau électriquement conducteur comporte au moins une portion de titane disposée entre une portion de tungstène et une portion à base de nitrure de titane.

8. Procédé de réalisation d'un circuit intégré (100), comportant au moins les étapes de :
- réalisation d'au moins un premier transistor (101a) de type MOS,
- réalisation d'au moins une portion (117) d'au moins un matériau électriquement conducteur reliée électriquement à une grille (113a) du premier transistor (101a),
- dépôt d'au moins une couche diélectrique (129) recouvrant au moins la portion (117) du matériau électriquement conducteur,
- réalisation d'au moins un second transistor de type MOS (101b) sur le premier transistor (101a), une région de canal (109b) du second transistor (101b) étant formée dans au moins une couche (104b) à base de semi-conducteur comportant deux faces principales (106b, 108b) sensiblement parallèles et disposée sur la couche diélectrique (129), la portion (117) du matériau électriquement conducteur étant disposée entre la grille (113a) du premier transistor (101a) et la région de canal (109b) du second transistor (101b),
et dans lequel
la section de la région de canal (109b) du second transistor (101b) dans un plan parallèle aux deux faces principales (106b, 108b) de la couche à base de semi-conducteur est incluse dans la section de la portion (117) du matériau électriquement conducteur projetée dans ledit plan, et
la région de canal (109b) du second transistor (101b) est disposée entre la portion (117) du matériau électriquement conducteur et une grille (113b) du second transistor (101b).

9. Procédé selon la revendication 8, dans lequel l'étape de réalisation de la portion (117) du matériau électriquement conducteur est obtenue par la mise en oeuvre des étapes suivantes :
- dépôt conforme d'une première couche diélectrique (121) sur le premier transistor (101a),
- dépôt d'une seconde couche diélectrique (123) sur la première couche diélectrique (121),
- planarisation de la seconde couche diélectrique (123) avec arrêt sur la première couche diélectrique (121), révélant une partie de la première couche diélectrique (121) recouvrant le sommet de la grille (113a) du premier transistor (101a),
- gravure de ladite partie de la première couche diélectrique (121), révélant au moins le sommet de la grille (113a) du premier transistor (101a),
- dépôt d'au moins une couche (127) à base du matériau électriquement conducteur au moins sur la grille (113a) du premier transistor (101a) et sur des portions restantes (125) de la seconde couche diélectrique (123),
- planarisation de la couche (127) à base du matériau électriquement conducteur, formant la portion (117) du matériau électriquement conducteur reliée électriquement à la grille (113a) du premier transistor (101a).
